# EUROPEAN PATENT APPLICATION

(11) **EP 2 375 307 A1**
(43) Date of publication of application: **12.10.2011**
(21) Application number: 10159419.0
(22) Date of filing: 08.04.2010
(51) Int. Cl.: G06F 3/01, G06F 3/048

(54) **Handheld device with localized thresholds for tactile feedback**

(71) Applicant: RESEARCH IN MOTION LIMITED, Waterloo, Ontario N2L 3W8 (CA)
(72) Inventor: Tong, Kuo-Feng, Waterloo Ontario N2L 3W8 (CA); Kwok, Jordanna, Markham Ontario L3P 7J4 (CA); Grant, Christopher J., Waterloo Ontario N2L 5R9 (CA)
(74) Representative: Fennell, Gareth Charles

(57) **Abstract**

A method includes detecting a touch at a touch location on a touch-sensitive display of an electronic device, identifying a first threshold value associated with the touch location, comparing the first threshold value to a force value related to the touch, and providing a first tactile feedback in response to determining that the force value meets the first threshold value.

## Description

### FIELD OF TECHNOLOGY

The present disclosure relates to portable electronic devices, including but not limited to portable electronic devices having touch-sensitive displays and their control.

### BACKGROUND

Electronic devices, including portable electronic devices, have gained widespread use and may provide a variety of functions including, for example, telephonic, electronic messaging and other personal information manager (PIM) application functions. Portable electronic devices include, for example, several types of mobile stations such as simple cellular telephones, smart telephones, wireless personal digital assistants (PDAs), and laptop computers with wireless 802.11 or Bluetooth capabilities.

Portable electronic devices such as PDAs or smart telephones are generally intended for handheld use and ease of portability. Smaller devices are generally desirable for portability. A touch-sensitive display, also known as a touchscreen display, is particularly useful on handheld devices, which are small and have limited space for user input and output. The information displayed on the touch-sensitive displays may be modified depending on the functions and operations being performed. With continued demand for decreased size of portable electronic devices, touch-sensitive displays continue to decrease in size.

Improvements in devices with touch-sensitive displays are desirable.

### SUMMARY

A method includes detecting a touch at a touch location on a touch-sensitive display of an electronic, identifying a first threshold value associated with the touch location, comparing the first threshold value to a force value related to the touch, and providing a first tactile feedback in response to determining that the force value meets the first threshold value.

A computer-readable medium having computer-readable code executable by at least one processor of a portable electronic device to perform the above method.

An electronic device includes a touch-sensitive display configured to detect a touch at a touch location, an actuator arranged and constructed to provide a first tactile feedback utilizing the touch-sensitive display, a force sensor configured to determine a force value related to the touch, and at least one processor operably connected to the touch-sensitive display, the actuator and the force sensor and configured to identify a first threshold value associated with the touch location, compare the first threshold value to the force value of the touch, and actuate the actuator to provide a first tactile feedback in response to determining that the force value meets the first threshold value.

### BRIEF DESCRIPTION OF THE DRAWINGS

FIG. 1 is a block diagram of a portable electronic device in accordance with the present disclosure.

FIG. 2 illustrates a front view of a portable electronic device in accordance with the present disclosure.

FIG. 3 illustrates a cross-sectional view through the line 202 of FIG. 2 in accordance with the present disclosure.

FIG. 4 is a block diagram showing components of the portable electronic device in accordance with the present disclosure;

FIG. 5 is a flowchart illustrating a method of providing tactile feedback at a portable electronic device in accordance with the present disclosure.

FIG. 6 and FIG. 7 illustrate examples of a touch on a touch-sensitive display of a portable electronic device in accordance with the present disclosure.

### DETAILED DESCRIPTION

The following describes an electronic device and a method including detecting a touch at a touch location on a touch-sensitive display of the electronic device, identifying a first threshold value associated with the touch location, comparing the first threshold value to a force value related to the touch, and providing a first tactile feedback in response to determining that the force value meets the first threshold value.

For simplicity and clarity of illustration, reference numerals may be repeated among the figures to indicate corresponding or analogous elements. Numerous specific details are set forth to provide a thorough understanding of the embodiments described herein. The embodiments may be practiced without these specific details. In other instances, well-known methods, procedures, and components have not been described in detail so as not to obscure the embodiments described herein. The description is not to be considered as limited to the scope of the embodiments described herein.

The disclosure generally relates to an electronic device, which in the embodiments described herein is a portable electronic device. Examples of portable electronic devices include mobile, or handheld, wireless communication devices such as pagers, cellular phones, cellular smart-phones, wireless organizers, personal digital assistants, wirelessly enabled notebook computers, and the like. The portable electronic device may also be a portable electronic device without wireless communication capabilities such as a handheld electronic game device, digital photograph album, digital camera, or other device.

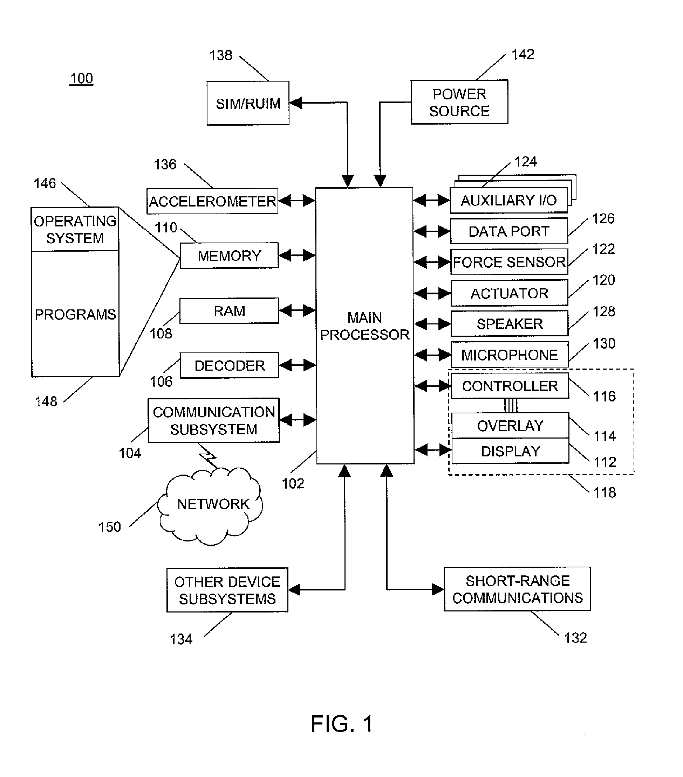

A block diagram of an example of a portable electronic device 100 is shown in FIG. 1. The portable electronic device 100 includes multiple components, such as a processor 102 that controls the overall operation of the portable electronic device 100. Communication functions, including data and voice communications, are performed through a communication subsystem 104. Data received by the portable electronic device 100 is decompressed and decrypted by a decoder 106. The communication subsystem 104 receives messages from and sends messages to a wireless network 150. The wireless network 150 may be any type of wireless network, including, but not limited to, data wireless networks, voice wireless networks, and dual-mode networks that support both voice and data communications. A power source 142, such as one or more rechargeable batteries or a port to another power supply, powers the portable electronic device 100.

The processor 102 interacts with other devices, such as a Random Access Memory (RAM) 108, memory 110, a display 112 with a touch-sensitive overlay 114 operably connected to an electronic controller 116 that together comprise a touch-sensitive display 118, one or more actuators 120, one or more force sensors 122, an auxiliary input/output (I/O) subsystem 124, a data port 126, a speaker 128, a microphone 130, short-range communications 132 and other device subsystems 134. User-interaction with a graphical user interface is performed through the touch-sensitive overlay 114. The processor 102 interacts with the touch-sensitive overlay 114 via the electronic controller 116. Information, such as text, characters, symbols, images, icons, links, and other items that may be displayed or rendered on a portable electronic device, is displayed on the touch-sensitive display 118 via the processor 102. The processor 102 may also interact with an accelerometer 136 that may be utilized to detect direction of gravitational forces or gravity-induced reaction forces.

To identify a subscriber for network access, the portable electronic device 100 uses a Subscriber Identity Module or a Removable User Identity Module (SIM/RUIM) card 138 for communication with a network, such as the wireless network 150. Alternatively, user identification information may be programmed into the memory 110.

The portable electronic device 100 also includes an operating system 146 and software programs or components 148 that are executed by the processor 102 and are typically stored in a persistent, updatable store such as the memory 110. Additional applications or programs may be loaded onto the portable electronic device 100 through the wireless network 150, the auxiliary I/O subsystem 124, the data port 126, the short-range communications subsystem 132, or any other suitable subsystem 134.

A received signal such as a text message, an e-mail message, or web page download is processed by the communication subsystem 104 and input to the processor 102. The processor 102 processes the received signal for output to the display 112 and/or to the auxiliary I/O subsystem 124. A subscriber may generate data items, for example e-mail messages, which may be transmitted over the wireless network 150 through the communication subsystem 104. For voice communications, the overall operation of the portable electronic device 100 is similar. The speaker 128 outputs audible information converted from electrical signals, and the microphone 130 converts audible information into electrical signals for processing.

The touch-sensitive display 118 may be any suitable touch-sensitive display, such as a capacitive, resistive, infrared, or surface acoustic wave (SAW) touch-sensitive display, as known in the art. A capacitive touch-sensitive display includes the display 112 and a capacitive touch-sensitive overlay 114. The overlay 114 may be an assembly of multiple layers in a stack including, for example, a substrate, LCD display 112, a ground shield layer, a barrier layer, one or more capacitive touch sensor layers separated by a substrate or other barrier, and a cover. The capacitive touch sensor layers may be any suitable material, such as patterned indium tin oxide (ITO).

One or more touches, also known as touch contacts or touch events, may be detected by the touch-sensitive display 118. The processor 102 may determine attributes of the touch, including a location of a touch. Touch location data may include an area of contact or a single point of contact, such as a point at or near a center of the area of contact. The location of a detected touch may include x and y components, e.g., horizontal and vertical components, respectively, with respect to one's view of the touch-sensitive display 118. For example, the x location component may be determined by a signal generated from one touch sensor, and the y location component may be determined by a signal generated from another touch sensor. A signal is provided to the controller 116 in response to detection of a touch. A touch may be detected from any suitable object, such as a finger, thumb, appendage, or other items, for example, a stylus, pen, or other pointer, depending on the nature of the touch-sensitive display 118. Multiple simultaneous touches may be detected.

The actuator 120 may be depressed by applying sufficient force to the touch-sensitive display 118 to overcome the actuation force of the actuator 120. The actuator 120 may be actuated by pressing anywhere on the touch-sensitive display 118. The actuator 120 may provide input to the processor 102 when actuated. Actuation of the actuator 120 provides the user with tactile feedback.

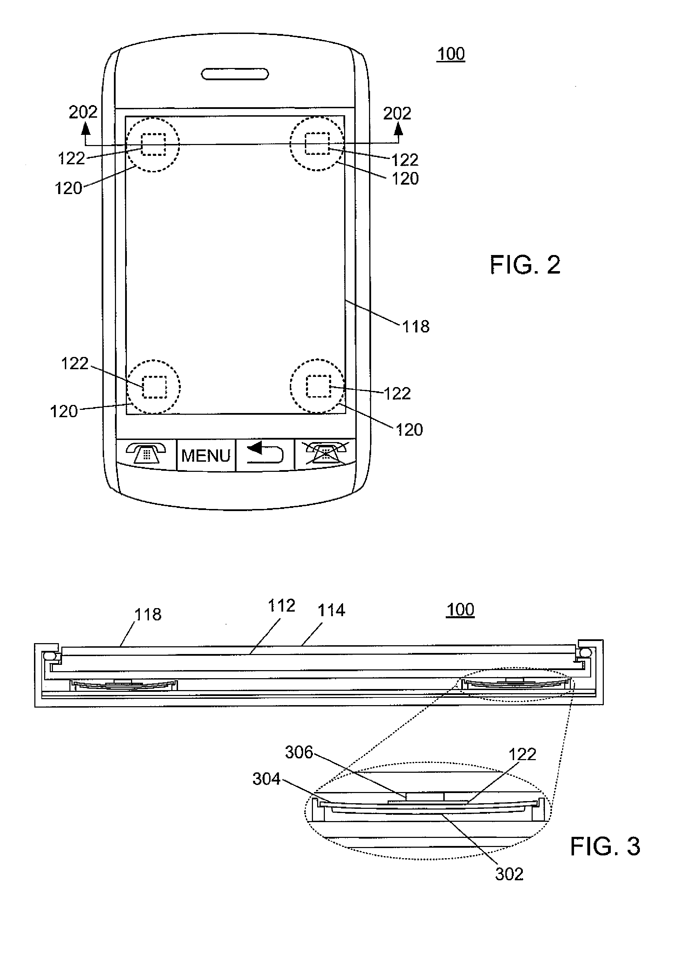

The actuator 120 may comprise one or more piezoelectric (piezo) actuators that provide tactile feedback. FIG. 2 is front view of an example of a portable electronic device 100. In the example shown in FIG. 2, the actuator 120 comprises four piezo actuators 120, each located near a respective corner of the touch-sensitive display 118. FIG. 3 is a sectional side view of the portable electronic device 100 through the line 202 of FIG 2. Each piezo actuator 120 is supported within the portable electronic device 100 such that contraction of the piezo actuators 120 applies a force against the touch-sensitive display 118, for example, opposing a force externally applied to the display 118. Each piezo actuator 120 includes a piezoelectric device 302, such as a piezoelectric disk that may be adhered to a substrate 304 such as a metal substrate. An element 306 that is advantageously at least partially flexible and comprises, for example, hard rubber may be located between the piezoelectric device 302 and the touch-sensitive display 118. The element 306 does not substantially dampen the force applied to or on the touch-sensitive display 118. In the example shown in FIG. 2 and FIG. 3, the force sensor 122 comprises four force-sensors 122 located between the element 306 and the substrate 304. The force sensors 122 are utilized to determine a value related to the force at each of the force sensors 122 when an external force is applied to the touch-sensitive display 118. The substrate 304 bends when the piezoelectric device 302 contracts diametrically due to build up of charge/voltage at the piezoelectric device 302 or in response to an external force applied to the touch-sensitive display 118. The charge/voltage may be adjusted by varying the applied current/voltage, thereby controlling the force applied by the piezo actuators 120 on the touch-sensitive display 118. The charge/voltage on the piezo actuators 120 may be removed by a controlled discharge current/voltage that causes the piezoelectric devices 302 to expand diametrically, decreasing the force applied by the piezo actuators 120 on the touch-sensitive display 118. Absent an external force applied to the touch-sensitive display 118 and absent a charge/voltage on the piezoelectric device 302, the piezo actuator 120 may be slightly bent due to a mechanical preload.

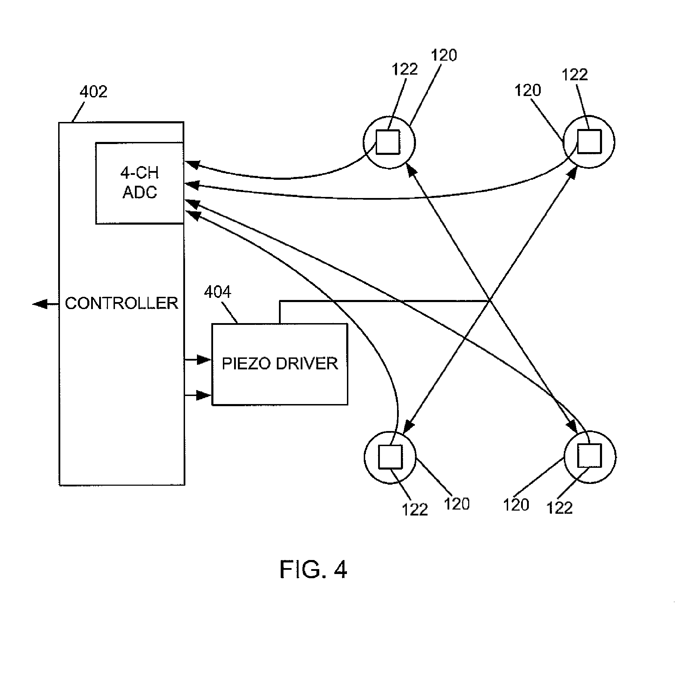

A block diagram of components of the portable electronic device 100 is shown in FIG. 4. In this example, each force sensor 122 is connected to a controller 402, which includes an amplifier and analog-to-digital converter (ADC). The force sensors 122 may be, for example, force sensing resistors in an electrical circuit such that the resistance changes with force imparted on the force sensors 122. As applied force to the touch-sensitive display 118 increases, the resistance decreases. This change is determined via the controller 116 for each of the force sensors 122, and a value representative of force at each of the force sensors 122 is determined. A force value related to the applied force of the touch may be determined utilizing the values representative of force from the force sensors 122.

The piezo actuators 120 are connected to a piezo driver 404 that communicates with the controller 402. The controller 402 is also in communication with the main processor 102 of the portable electronic device 100 and may receive and provide signals to and from the main processor 102. The piezo actuators 120 and the force sensors 122 are operatively connected to the main processor 102 via the controller 402. The controller 402 controls the piezo driver 404 that controls the current/voltage to the piezoelectric devices 302 and thus controls the charge/voltage and the force applied by the piezo actuators 120 on the touch-sensitive display 118. Each of the piezoelectric devices 302 may be controlled substantially equally and concurrently. Optionally, the piezoelectric devices 302 may be controlled separately. In the example described below, collapse and release of a dome switch is simulated. Other switches, actuators, keys, and so forth may be simulated, or a non-simulated tactile feedback may be provided. When the force value related to the applied force on the touch-sensitive display 118, meets a depression threshold, the charge/voltage at the piezo actuators 120 is varied to impart a force on the touch-sensitive display 118 to simulate collapse of a dome switch. When the force value meets a release threshold, after actuation of the piezo actuators 120, the charge/voltage at the piezo actuators 120 is varied to impart a force, by the piezo actuators 120, to simulate release of a dome switch. A value meets a threshold when the value is at or beyond the threshold.

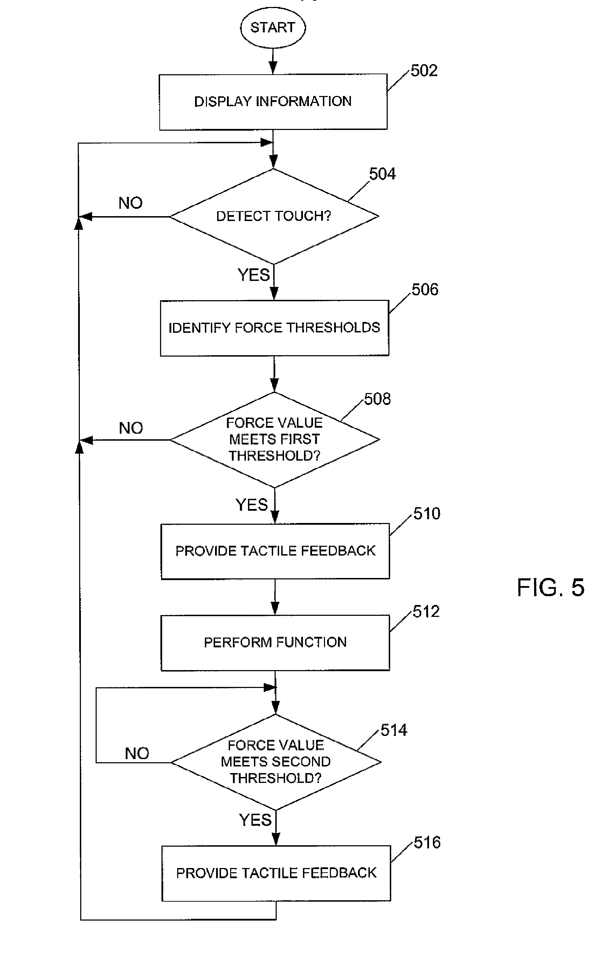

A flowchart illustrating a method of providing tactile feedback at the electronic device 100 is shown in FIG. 5. The method may be carried out by software executed by, for example, the processor 102. Coding of software for carrying out such a method is within the scope of a person of ordinary skill in the art given the present description. The method may contain additional or fewer processes than shown and/or described, and may be performed in a different order. Computer-readable code executable by at least one processor of the portable electronic device to perform the method may be stored in a computer-readable medium.

Information is displayed 502 on the display 112. The information may be from an application, such as a web browser, contacts, email, calendar, music player, spreadsheet, word processing, operating system interface, and so forth.

When a touch is detected at a touch location on the touch-sensitive display 118, a depression force threshold and a release force threshold associated with the touch location are identified 506. The depression force threshold and the release force threshold are based on the touch location. These thresholds may be identified utilizing, for example, a look-up table or any other suitable method of associating the thresholds with locations on the touch-sensitive display 118. A force value related to the touch on the touch-sensitive display 118, determined based on signals from the force sensors 122, is compared 508 to the depression force threshold. When the force value does not meet the depression force threshold, the process continues at 504. When the force value meets the depression force threshold, the process continues at 510. The force value may be repeatedly determined, e.g., at a predetermined sample rate. Tactile feedback is provided 510 by actuation of the piezoelectric actuators 120 to impart a force on the touch-sensitive display 118, for example, to simulate collapse of a dome switch. A function may also be performed 512 such as selection of a feature that is associated with the touch location on the touch-sensitive display 118. The force value is compared 514 to the release force threshold. When the force value meets the release force threshold, tactile feedback is provided 516, for example, by actuation of the piezoelectric actuators 120 to impart a force on the touch-sensitive display 118 to simulate release of a dome switch.

Optionally, an additional function may be performed when the value force value meets the release threshold. Alternatively, a function may be performed when the force value meets the release threshold rather than at 512. For example, the feature may be selected after the force value meets the release threshold.

The depression and release force thresholds are based on the location of the touch on the touch-sensitive display. The thresholds may be higher for a touch at an area associated with one feature than the thresholds at an area associated with another feature.

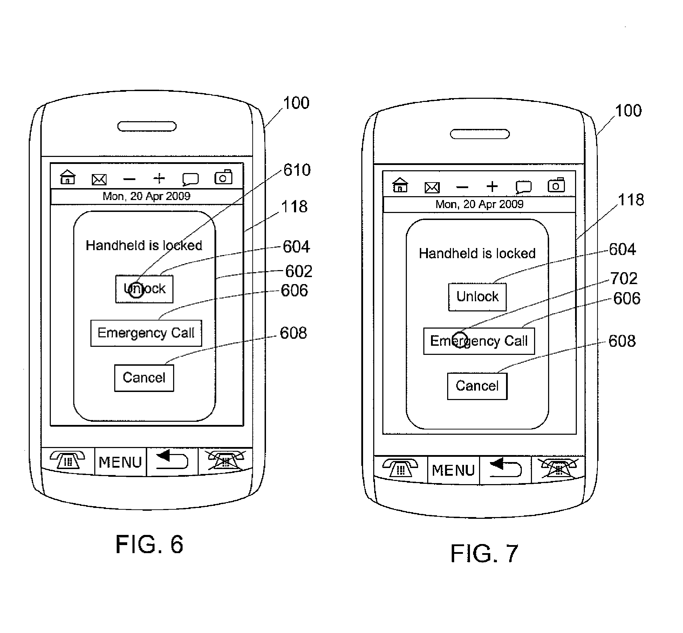

Examples of touches on a touch-sensitive display 118 of a portable electronic device 100 are shown in FIG. 6 and FIG. 7. In these examples, the portable electronic device 118 is locked, for example, to inhibit inadvertent selections. The menu 602 shown in FIG. 6 and FIG. 7 may be displayed in response to, for example, detecting a touch on the touch-sensitive display 118. Three menu options are displayed on the touch-sensitive display 118, including an "Unlock" option 604 to unlock the portable electronic device 118 for use, an "Emergency call" option 606 to make, for example, a 911 call, and a "Cancel" option 608 to exit the menu. In the example of FIG. 6, a touch 610 is detected at a touch location that is associated with the "Unlock" option 604. The force thresholds associated with the touch location are identified. In the example of FIG. 7, a touch 702 is detected at a touch location that is associated with the "Emergency Call" option 606. The force thresholds associated with the touch location are identified.

The depression threshold associated with the "Emergency Call" touch location 702 may be greater than the depression threshold associated with the "Unlock" touch location 610. The applied force to actuate the piezo actuators 120 to provide tactile feedback and to perform the associated function, which in this example is to dial 911, is greater than the applied force to actuate the piezo actuators 120 to provide tactile feedback and perform the function to unlock the portable electronic device 100. The release threshold associated with the touch location 702 may be greater than the release threshold associated with the touch location 610.

In the example of FIG. 6 and FIG. 7, the thresholds are the same for different touch locations that fall within the area associated with the "Unlock" option 604. The thresholds are the same for different touch locations that fall within the area associated with the "Emergency Call" option 606. The thresholds are the same for different touch locations that fall within the area associated with the "Cancel" option 608. The thresholds, however, differ for touch locations that fall within the area associated with the "Unlock" option 604 compared to the thresholds for touch locations that fall within the area associated with the "Emergency Call" option 606.

Force thresholds for selection of features on the touch-sensitive display may vary. Different force thresholds may be utilized to inhibit inadvertent selection of a feature or features on the portable electronic device 100 and inhibit performance or execution of associated functions. For example, different force thresholds may be utilized to inhibit 911, or emergency calls, or other speed dial calls. A decrease in inadvertent or unwanted execution or performance of functions may decrease device use time and power requirements and increase time between charging of the battery.

The present disclosure may be embodied in other specific forms without departing from its spirit or essential characteristics. The described embodiments are to be considered in all respects only as illustrative and not restrictive. The scope of the present disclosure is, therefore, indicated by the appended claims rather than by the foregoing description. All changes that come within the meaning and range of equivalency of the claims are to be embraced within their scope.

## Claims

1. A method comprising:
detecting a touch at a touch location on a touch-sensitive display of an electronic device;
identifying a first threshold value associated with the touch location;
comparing the first threshold value to a force value related to the touch;
providing first tactile feedback in response to determining that the force value meets the first threshold value.

2. The method according to claim 1, comprising determining the force value prior to providing tactile feedback.

3. The method according to claim 1, comprising repeatedly determining the force value.

4. The method according to claim 1, comprising identifying a second threshold value associated with the touch location.

5. The method according to claim 4, comprising comparing the force value to the second threshold after providing the first tactile feedback.

6. The method according to claim 5, comprising providing a second tactile feedback when the force meets the second threshold value.

7. The method according to claim 5, comprising performing a function associated with the touch location in response to determining that the force value meets the second threshold value.

8. The method according to claim 1, comprising displaying information on the touch-sensitive display prior to detecting the touch.

9. The method according to claim 1, wherein the first threshold value is associated with an area of the touch-sensitive display, which area is associated with displayed information.

10. The method according to claim 1, comprising performing a function associated with the touch location in response to determining that the force value meets the first threshold value.

11. The method according to claim 1, wherein the first tactile feedback is provided utilizing an actuator arranged and constructed to impart a force on the touch-sensitive display.

12. The method according to claim 1, wherein the first tactile feedback comprises simulation of depression of a switch.

13. A computer-readable medium having computer-readable code executable by at least one processor of a portable electronic device to perform the method of claim 1.

14. An electronic device comprising:
a touch-sensitive display configured to detect a touch at a touch location;
an actuator arranged and constructed to provide a first tactile feedback utilizing the touch-sensitive display;
a force sensor configured to determine a force value related to the touch;
at least one processor operably connected to the touch-sensitive display, the actuator and the force sensor and configured to identify a first threshold value associated with the touch location, compare the first threshold value to the force value, and actuate the actuator to provide first tactile feedback in response to determining that the force value meets the first threshold value.

15. The electronic device according to claim 14, comprising memory operatively coupled to the at least one processor and having stored thereon, the first threshold value associated with the touch location.

16. The electronic device according to claim 15, wherein the first threshold value is stored, in association with the touch location, in a look-up table.

17. The electronic device according to claim 14, wherein the actuator comprises a piezoelectric actuator.

18. The electronic device according to claim 14, wherein the actuator comprises a plurality of piezoelectric actuators.

## Amended claims

### Amended claims in accordance with Rule 137(2) EPC.

**1.** A method comprising:
detecting a touch at a touch location on a touch-sensitive display (118) of an electronic device (100);
identifying a first threshold value associated with the touch location;
comparing the first threshold value to a force value related to the touch;
providing first tactile feedback in response to determining that the force value meets the first threshold value;
identifying a second threshold value associated with the touch location;
comparing the force value to the second threshold value after providing the first tactile feedback;
providing a second tactile feedback in response to determining that the force value meets the second threshold value.

**2.** The method according to claim 1, comprising determining the force value prior to providing tactile feedback.

**3.** The method according to claim 1, comprising repeatedly determining the force value.

**4.** The method according to claim 1, comprising performing a function associated with the touch location in response to determining that the force value meets the second threshold value.

**5.** The method according to any one of claims 1 to 4, comprising displaying information on the touch-sensitive display (118) prior to detecting the touch.

**6.** The method according to claim 1, wherein the first threshold value is associated with an area of the touch-sensitive display, which area is associated with displayed information.

**7.** The method according to any one of claims 1 to 6, comprising performing a function associated with the touch location in response to determining that the force value meets the first threshold value.

**8.** The method according to any one of claims 1 to 7, wherein the first tactile feedback is provided utilizing an actuator (120) arranged and constructed to impart a force on the touch-sensitive display (118).

**9.** The method according to any one of claims 1 to 8, wherein the first tactile feedback comprises simulation of depression of a switch.

**10.** A computer-readable medium having computer-readable code executable by at least one processor (102) of an electronic device (100) to perform the method of any one of claims 1 to 9.

**11.** An electronic device (100) comprising:
a touch-sensitive display (118) configured to detect a touch at a touch location;
an actuator (120) arranged and constructed to provide a first tactile feedback utilizing the touch-sensitive display (118);
a force sensor (122) configured to determine a force value related to the touch;
at least one processor (102) operably connected to the touch-sensitive display (118), the actuator (120) and the force sensor (122) and configured to identify a first threshold value associated with the touch location, compare the first threshold value to the force value, actuate the actuator (120) to provide first tactile feedback in response to determining that the force value meets the first threshold value, identify a second threshold value associated with the touch location, compare the force value to the second threshold after providing the first tactile feedback, actuate the actuator (120) to provide second tactile feedback in response to determining that the force value meets the second threshold value.

**12.** The electronic device (100) according to claim 11, comprising memory (110) operatively coupled to the at least one processor (102) and having stored thereon, the first threshold value associated with the touch location.

**13.** The electronic device (100) according to claim 12, wherein the first threshold value is stored, in association with the touch location, in a look-up table.

**14.** The electronic device (100) according to any one of claims 11 to 13, wherein the actuator (120) comprises a piezoelectric actuator.

**15.** The electronic device (100) according to any one of claims 11 to 14, wherein the actuator (120) comprises a plurality of piezoelectric actuators.
